# EUROPÄISCHE PATENTSCHRIFT

(11) **EP 4 028 783 B1**
(45) Veröffentlichungstag und Bekanntmachung des Hinweises auf die Patenterteilung: **06.11.2024**
(21) Anmeldenummer: 20771526.9
(22) Anmeldetag: 09.09.2020
(51) Int. Cl.: G01R 19/00, G01R 19/165

(54) **BATTERIESENSOR**
BATTERY SENSOR
CAPTEUR DE BATTERIE

(30) Priorität: 11.09.2019 DE 102019213885
(43) Veröffentlichungstag der Anmeldung: 20.07.2022
(73) Patentinhaber: Continental Automotive Technologies GmbH, 30175 Hannover (DE)
(72) Erfinder: FRIMBERGER, Manfred, 60488 Frankfurt am Main (DE); KALBECK, Alexander, 60488 Frankfurt am Main (DE); SCHRAMME, Martin, 60488 Frankfurt am Main (DE); WARNKE, Karlheinz, 60488 Frankfurt am Main (DE)
(74) Vertreter: Continental Corporation
(86) Internationale Anmeldenummer: PCT/EP2020/075240
(87) Internationale Veröffentlichungsnummer: WO 2021/048232

(56) Entgegenhaltungen:
- EP-A1- 2 623 996
- WO-A1-2016/008649
- DE-A1- 102014 202 622
- DE-A1- 102017 223 535
- DE-B3- 102004 022 556

## Beschreibung

Die Erfindung betrifft einen Batteriesensor zur Erfassung von zumindest einem Batterieparameter.

Batteriesensor werden in Fahrzeugen genutzt, Batterieparameter, beispielsweise den Batteriestrom oder die Batteriespannung der Fahrzeugbatterie zu erfassen. Beispielsweise weist ein solcher Batteriesensor eine im Strompfad angeordnete Messstrecke auf, entlang der Messwerte erfasst werden, aus denen ein Batterieparameter ermittelt werden kann.

Der Batteriesensor muss über die gesamte Lebensdauer eine hohe Genauigkeit aufweisen, um den Batteriezustand möglichst genau bestimmen zu können. Des Weiteren ist sicherzustellen, dass Fehler in der Bestimmung der Batterieparameter, insbesondere bei der Bestimmung der Batteriespannung oder des Batteriestroms, mit einer hohen Zuverlässigkeit erkannt und/oder vermieden werden. Aus der DE 10 2014 202 622 A1 ist beispielsweise ein Batteriemanagementsystme bekannt, bei dem für mehrere Batteriezellen der Batteriemodule jeweils eine Sensoreinheit vorgesehen ist, um die einzelnen Batteriezellen odert Batteriemodule zu überwachen.

Aus dem Stand der Technik ist beispielsweise bekannt, eine vollständig redundante Messung der Batterieparameter bereitzustellen. Aus der DE 10 2017 223 535 A1 ist beispielsweise ein Batteriesensor mit zwei parallelen Meßeinheiten bekannt. Diese erfordert aber sehr hohen konstruktiven Aufwand, da zwei vollständig getrennte Messpfade aufgebaut werden müssen, beispielsweise mit zwei vollständig getrennten Batteriesensoren. Zudem erfordert ein solcher Aufbau einen sehr hohen Platzbedarf.

Weitere Batteriesensoren sind aus der DE 10 2004 022 556 B3, der WO 2016 008 649 A1 und der EP 2 623 996 A1 bekannt.

Aufgabe der Erfindung ist es, einen Batteriesensor bereitzustellen, der Fehler in der Messung der Batterieparameter mit einer sehr hohen Zuverlässigkeit erkennen und oder vermeiden kann und einen sehr kompakten Aufbau aufweist.

Zur Lösung der Aufgabe ist ein Batteriesensor zur Erfassung von zumindest einem Batterieparameter vorgesehen, mit zumindest zwei Messeinheiten, wobei die Messeinheiten jeweils zumindest eine Erfassungseinrichtung zur Erfassung zumindest eines Messwertes aufweisen. Die Messeinheiten weisen jeweils zumindest eine Auswerteschaltung zur Ermittlung zumindest eines Batterieparameters aus dem jeweils erfassten zumindest einen Messwert auf. Es ist zumindest eine Auswerteeinheit vorgesehen, die die von den Auswerteschaltungen ermittelten Batterieparameter vergleicht und bei Überschreiten einer definierten Abweichung zwischen den Batterieparametern ein Fehlersignal ausgibt.

Der Batteriesensor hat also zwei unabhängig voneinander funktionierende Messeinheiten, die jeweils den oder dieselben Batterieparameter ermitteln. Die ermittelten Batterieparameter beider Messeinheiten werden, vorzugsweise innerhalb des Batteriesensors, miteinander verglichen. Da beide Messeinheiten dieselben Messwerte erfassen, müssen die ermittelten Batterieparameter übereinstimmen bzw. dürfen nur um einen definierten Wert voneinander abweichen. Wird diese Abweichung überschritten, wird ein Fehlersignal ausgegeben. Innerhalb des Batteriesensors werden also für einen Batterieparameter zumindest zwei Messpfade bereitgestellt, die miteinander verglichen werden können. Dadurch, dass die Messpfade auf dieselben Messwerte zurückgreifen, ist sichergestellt, dass diese bei korrekter Funktionsweise gleiche bzw. nur geringfügig voneinander abweichende Batterieparameter ermitteln. Beispielsweise können die Messeinheiten auch gemeinsame Kontakte zur Erfassung der Messwerte aufweisen. Dadurch kann die Anzahl der Kontakte reduziert werden und zudem sichergestellt werden, dass die Messeinheiten die gleichen Messwerte erfassen. Abweichungen der ermittelten Batterieparameter müssen somit durch Fehler innerhalb der Messeinheiten verursacht werden, sodass eine Eingrenzung der Fehlerquelle möglich ist.

Um den Batteriesensor möglichst kompakt zu gestalten, kann in zumindest einer Auswerteschaltung eine Auswerteeinheit integriert sein, wobei die Auswerteschaltungen über eine Signalleitung miteinander verbunden sind, über die die Batterieparameter an die Auswerteeinheit übermittelt werden. Das heißt, es ist keine zusätzliche Schaltung erforderlich, um die Batterieparameter miteinander zu vergleichen. Dies erfolgt in einer der Messeinheiten. Um die Genauigkeit zusätzlich zu erhöhen, können auch in mehreren Messeinheiten Auswerteeinheiten vorhanden sein, wobei deren Werte ebenfalls miteinander verglichen werden können.

Die Auswerteeinheit kann auch in einer übergeordneten Steuerung, beispielsweise einer Fahrzeugsteuerung vorgesehen sein, wodurch der Batteriesensor kleiner gestaltet werden kann.

Zusätzlich kann in zumindest eine Messeinheit eine Diagnoseeinheit zur Durchführung eines Selbsttest der Messeinheit und/oder zumindest einer Erfassungseinrichtung vorgesehen sein. Die jeweilige Messeinheit kann also eine Selbstdiagnose oder eine Kalibrierung durchführen. Dadurch kann die Zuverlässigkeit bzw. die Genauigkeit des Batteriesensors zusätzlich erhöht werden. Durch die Selbstdiagnose können zusätzlich Fehler innerhalb der jeweiligen Messeinheit erkannt werden, wodurch auch eine Fehlererkennung möglich ist, wenn beide Messeinheiten einen Fehler aufweisen, der zur Ausgabe gleicher oder ähnlicher Batterieparameter führen könnte. Durch die Kalibrierung ist zudem die Erhöhung der Genauigkeit der jeweiligen Messeinheit möglich, sodass zusätzlich die Messgenauigkeit des gesamten Batteriesensors erhöht werden kann.

Die Messeinheiten können sich im Aufbau und/oder in der Art der Ermittlung der Batterieparameter unterscheiden. Dadurch ist es möglich, dass systembedingte Fehler, denen beide Messeinheiten unterliegen könnten, gleichartige Fehler in beiden Messeinheiten, beispielsweise aufgrund der gleichen Ursache, zu erkennen. Beispielsweise kann jeweils eine der Messeinheiten zusätzliche Elemente zur Verbesserung der Genauigkeit oder zur Kalibrierung der Messeinheit aufweisen.

Beispielsweise kann zumindest einer Erfassungseinrichtung einer Messeinheit ein Filter für den Messwert vorgeschaltet sein. Insbesondere kann auch ein gemeinsamer Filter für korrespondierende Erfassungseinrichtungen von mehreren Messeinheiten vorgesehen sein.

Die Messwerte können beispielsweise auch temperasturabhängig sein. Zur Erhöhung der Messgenauigkeit können die Messeinheiten jeweils eine Temperaturerfassungsschaltung, insbesondere mit einem innerhalb der Messeinheit angeordneten Temperatursensor, aufweisen, wobei die ermittelte Temperatur an die Auswerteschaltung ausgegeben wird. Der Batterieparameter wird aus dem jeweils erfassten ersten Messwert und dem jeweils erfassten zweiten Messwert und der ermittelten Temperatur ermittelt. Beispielsweise kann die Messstrecke ein Widerstandselement aufweisen und durch die Messeinheit wird ein Spannungsabfall entlang der Messstrecke bzw. des Widerstandselements erfasst. Aus dem erfassten Spannungsabfall sowie dem bekannten elektrischen Widerstand des Widerstandselements kann beispielsweise der Batteriestrom ermittelt werden. Da sich der elektrische Widerstand des Widerstandselements temperaturbedingt ändern kann, ist es erforderlich, die Temperatur zu erfassen, um den genauen elektrischen Widerstand des Widerstandselements zu ermitteln.

Zumindest eine Temperaturerfassungsschaltung kann mit einem außerhalb der Messeinheit angeordneten Temperatursensor verbunden sein. Diese Temperaturerfassungsschaltung kann durch den externen Temperatursensor die Temperaturerfassung mit dem internen Temperatursensor überprüfen, sodass der interne Temperatursensor entweder kalibriert werden kann oder dessen Fehlfunktion erkannt werden kann. Der externe Temperatursensor kann beispielsweise auf einer gemeinsamen Leiterplatte des Batteriesensors angeordnet sein oder vollständig außerhalb des Batteriesensors.

Des Weiteren kann zumindest eine Messeinheit eine Referenzschaltung zur Bereitstellung eines Referenzsignals aufweisen. Das Referenzsignal hat eine bekannte Größe. Des Weiteren ist bekannt, welcher Batterieparameter bzw. welche Änderung des Batterieparameters durch das Referenzsignal erzeugt wird. Durch das Referenzsignal kann entweder die entsprechende Messeinheit kalibriert werden. Alternativ kann der Batterieparameter der jeweiligen Messeinheit zusätzlich das Referenzsignal enthalten. In der Auswerteeinheit kann beispielsweise das Referenzsignal herausgefiltert bzw. die Änderung des Batterieparameters durch das Referenzsignal geprüft werden, wodurch ebenfalls ein Abgleich der Batterieparameter miteinander möglich ist.

Vorzugsweise sind die Messeinheiten auf einer gemeinsamen Leiterplatte angeordnet sodass der Batteriesensor möglichst kompakt ausgebildet ist. Insbesondere können die Messeinheiten auf entgegengesetzten Flächen der Leiterplatte angeordnet sein, um die Größe der Leiterplatte zu reduzieren.

Die Messeinheiten können auch mehrere Erfassungseinrichtungen aufweisen, wobei jeweils die gleichen Batterieparameter erfasst werden.

Eine erste Erfassungseinrichtung kann beispielsweise eine Spannungserfassungseinrichtung zur Erfassung der Batteriespannung sein, wobei die erste Erfassungseinrichtung insbesondere einen ersten Kontakt zur Kontaktierung mit einem Batteriepol der Fahrzeugbatterie aufweist.

Eine zweite Erfassungseinrichtung kann eine Stromerfassungseinrichtung zur Erfassung des Batteriestroms sein.

Die Stromerfassungseinrichtung kann eine Messstrecke aufweisen, wobei ein erster Messwert an einem ersten Kontakt an einem ersten Ende der Messstrecke erfasst wird und ein zweiter Messwert an einem zweiten Kontakt an einem zweiten Ende der Messstrecke erfasst wird.

Beispielsweise weist die Messstrecke zumindest einen Messwiderstand mit einem definierten elektrischen Widerstand auf, und die Messwerte sind jeweils Spannungen. Jede der Messeinheiten erfasst somit den Spannungsabfall entlang der Messstrecke. Mit dem bekannten elektrischen Widerstand des Messwiderstandes kann aus dem jeweils ermittelten Spannungsabfall der über den Batteriesensor verbessert werden die Messstrecke fließende Batteriestrom ermittelt werden.

Weitere Vorteile und Merkmale ergeben sich aus der nachfolgenden Zeitrechnung. In dieser ist ein schematischer Aufbau eines erfindungsgemäßen Batteriesensors gezeigt.

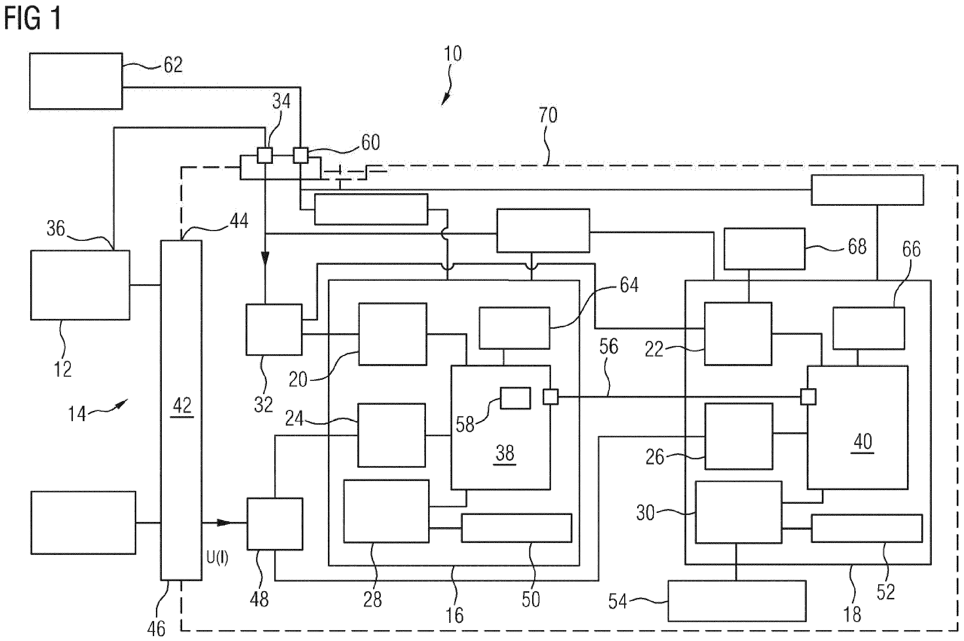

In Figur 1 ist ein Batteriesensor 10 gezeigt, zur Erfassung von Batterieparameter einer Fahrzeugbatterie 12, die in einem Stromkreis 14 in einem Fahrzeug angeordnet ist.

Der Batteriesensor 10 weist zwei Messeinheiten 16, 18 auf, die jeweils mehrere Erfassungseinrichtungen zur Erfassung zumindest eines Batterieparameters aufweisen, wobei beide Messeinheiten 16, 18 dieselben Batterieparameter erfassen. Eine erste Erfassungseinrichtung der Messeinheiten ist jeweils eine Spannungserfassungseinrichtung 20, 22 zur Erfassung der Batteriespannung, eine zweite Erfassungseinrichtung ist jeweils eine Stromerfassungseinrichtung 24, 26 zur Erfassung des Batteriestrom. Zusätzlich weist jede Messeinheit 16, 18 eine Temperaturerfassungsschaltung 28, 30 auf.

Die Spannungserfassungseinrichtungen 20, 22 sind über einen gemeinsamen Filter 32 mit einem Eingang 34 des Batteriesensors 10 verbunden. Der Eingang 34 ist mit einem Batteriepol 36 elektrisch verbunden, sodass die Spannungserfassungseinrichtungen 20, 22 denselben Messwert erhalten und an eine Auswerteschaltung 38, 40 ausgeben, die aus diesem Messwert die Batteriespannung der Fahrzeugbatterie 12 ermittelt.

Die Stromerfassungseinrichtungen 24, 26 weisen eine gemeinsame im Laststrompfad angeordnete Messstrecke 42 auf, die durch einen Messwiderstand mit einem definierten elektrischen Widerstand gebildet ist. Der Messwiderstand kann durch mehrere in Reihe und/oder parallel angeordnete Widerstandselemente gebildet sein. Ein erster Messwert ist eine an einem ersten Ende der Messstrecke erfasste Spannung, ein zweiter Messwert ist eine an einem zweiten Ende der Messstrecke erfasste Spannung. Aus diesen Spannungen kann in Auswerteschaltung 38, 40 jeweils der Spannungsabfall über die Messstrecke 42, also über den Messwiderstand berechnet und aus diesem zusammen mit dem bekannten elektrischen Widerstand des Messwiderstandes der über die Messstrecke fließende Strom, also der Batteriestrom, ermittelt werden. Da beide Messeinheiten 16, 18 auf eine gemeinsame Messstrecke zurückgreifen, sichergestellt, dass diese dieselben Messwerte 42 erhalten und somit bei korrekter Funktion der Messeinheiten 16, 18 dieselben Batterieparameter ausgeben müssen. Vor den Stromerfassungseinrichtungen 24, 26 ebenfalls ein gemeinsamer Filter 48 vorgesehen.

Die Temperaturerfassungsschaltung 28 der ersten Messeinheit 16 weist einen internen Temperatursensor 50 auf, dessen Signal ebenfalls an die Auswerteschaltung 38 ausgegeben wird. Mit dem Temperatursignal können beispielsweise die Messungen der Stromerfassungseinrichtung 20 oder der Spannungserfassungseinrichtung 24 korrigiert oder verbessert werden. Die Temperaturerfassungsschaltung 30 der zweiten Messeinheit 18 weist analog einen internen Temperatursensor 52 auf. Zusätzlich weist die Temperaturerfassungsschaltung 30 einen zweiten, externen Temperatursensor 54 auf. Dieser ermöglicht beispielsweise eine Überprüfung des internen Temperatursensor 52 oder die Erfassung zusätzlicher Temperaturdaten, beispielsweise um die Messung des Batteriesensors 10 zu verbessern.

Zwischen den Auswerteschaltungen 38, 40 ist eine Signalleitung 56 vorgesehen, über die die ermittelten Batterieparameter an die jeweils andere Auswerteschaltung 38, 40 ausgegeben werden können. In der Auswerteschaltung 38 der ersten Messeinheit 16 ist zusätzlich eine Auswerte Einheit 58 vorgesehen, die die Batterieparameter der Auswerteschaltung 38 und die Batterieparameter der Auswerteschaltung 40 miteinander vergleicht. Da diese jeweils auf denselben Messwerten passieren, müssen diese gleich sein oder dürfen nur geringfügige Abweichungen aufweisen. Überschreitet die Abweichung zwischen den korrespondierenden Batterieparametern der Auswerteschaltungen 38, 40 wird ein Fehlersignal ausgegeben insbesondere über einen Ausgang 60 an eine übergeordnete Steuerung 62, um eine Fehlfunktion des Batteriesensors 10 anzuzeigen.

Die ermittelten Batterieparameter beider Messeinheiten 16, 18 werden also innerhalb des Batteriesensors 10 überprüft, wobei die Batterieparameter jeweils auf denselben Messwerten beruhen. Die Fehlerquellen können somit auf die die Erfassungseinrichtungen 20, 22, 24, 26, 28, 30 und/oder die Auswerteschaltungen 38, 40 reduziert werden. Da die die Erfassungseinrichtungen 20, 22, 24, 26, 28, 30 jeweils dieselben Messwerte nutzen, kann die Anzahl der Kontakte zum Stromkreis 14 bzw. zur Fahrzeugbatterie 12 reduziert werden. Es erfolgt also eine redundante Messung der Batterieparameter, wobei innerhalb des Batteriesensors eine Fehler Überprüfung erfolgt. Der Batteriesensor ist somit sehr zuverlässig und weist nur eine geringe Baugröße auf, da für beide Messpfade keine getrennten Kontakte und/oder Messstrecken erforderlich sind.

Zusätzlich weisen beide Messeinheiten 16, 18 jeweils eine Diagnoseeinheit 64, 66 auf, um eine Selbstdiagnose durchzuführen. Die Diagnoseeinheiten 64, 66 können beispielsweise genutzt werden, um die Erfassungseinrichtungen 20, 22, 24, 26, 28, 30 im regulären Betrieb zu prüfen oder zu kalibrieren, insbesondere regelmäßig, und/ oder um nach Ausgabe eines Fehlersignals die Erfassungseinrichtungen 20, 22, 24, 26, 28, 30 oder die gesamten Messeinheiten 16, 18 zu prüfen.

In der hier gezeigten Ausführungsform weisen die Messeinheiten 16, 18 im Wesentlichen denselben Aufbau auf, d. h. die korrespondierenden Erfassungseinrichtungen 20, 22, 24, 26, 28, 30 weisen denselben Aufbau auf bzw. beruhen auf demselben Messverfahren. Es ist aber auch möglich, dass diese dieselben Messwerte verwenden, aber unterschiedliche Auswerteverfahren, um systembedingte Fehlerquellen zu vermeiden. Insbesondere können in den einzelnen Messeinheiten 16, 18 zusätzliche Elemente, beispielsweise Filter, Temperatursensoren oder Kalibriereinrichtungen vorgesehen sein, um gemeinsame Messfehler bei der Messeinheiten 14, 18, Spielweise aufgrund einer gemeinsamen Ursache, erkennen zu können.,

In der gezeigten Ausführungsform des Batteriesensors 10 ist beispielsweise eine für die Spannungserfassungseinrichtungen 22 eine Referenzspannungsquelle 68 vorgesehen, die eine definierte Spannung mit bekannter Größe an die Spannungserfassungseinrichtungen 22 anlegen kann, beispielsweise, um diese zu prüfen oder zu kalibrieren. Des Weiteren ist an der Temperaturerfassungsschaltung 30 ein externer Temperatursensor 54 vorgesehen, um diese zu kalibrieren oder der Auswerteschaltung 40 einen zusätzlichen Temperaturwert bereitstellen zu können. Weitere Elemente können beispielsweise Filter 32,48 sein, die nur die Messwerte einer der beiden Messeinheiten 16, 18 filtern.

In der hier gezeigten Ausführungsform sind die Messeinheiten 16, 18 auf einer gemeinsamen Leiterplatte 70, insbesondere nebeneinander, angeordnet. Vorzugsweise sind die Messeinheiten 1, 1in 68 auf entgegengesetzten Seiten der Leiterplatte 70 angeordnet, um die Leiterplatte kleiner ausbilden zu können.

Optional kann die Auswerteeinheit 48 auch außerhalb der Messeinheiten 16,18 angeordnet sein, insbesondere auch außerhalb des Batteriesensors 10.

## Patentansprüche

1. Batteriesensor (10) zur Erfassung von zumindest einem Batterieparameter, mit zumindest zwei Messeinheiten (16, 18), wobei die Messeinheiten (16, 18) jeweils zumindest eine Erfassungseinrichtung (20, 22, 24, 26, 28, 30) zur Erfassung zumindest eines Messwertes aufweisen, wobei die Messeinheiten (16, 18) jeweils zumindest eine Auswerteschaltung (38, 40) zur Ermittlung zumindest eines Batterieparameters aus dem jeweils erfassten zumindest einen Messwertes aufweisen, wobei zumindest eine Auswerteeinheit (58) vorgesehen ist, die die von den Auswerteschaltungen (38, 40) ermittelten Batterieparameter vergleicht und bei Überschreiten einer definierten Abweichung zwischen den Batterieparameter ein Fehlersignal ausgibt, **dadurch gekennzeichnet, dass** von den Messeinheiten jeweils derselbe Batterieparameter ermittelt wird.

2. Batteriesensor nach Anspruch 1, **dadurch gekennzeichnet, dass** in zumindest einer Auswerteschaltung (38, 40) eine Auswerteeinheit (58) integriert ist, wobei die Auswerteschaltungen (38, 40) über eine Signalleitung (56) miteinander verbunden sind, über die die Batterieparameter an die Auswerteeinheit (58) übermittelt werden.

3. Batteriesensor nach einem der vorhergehenden Ansprüche, **dadurch gekennzeichnet, dass** zumindest eine Messeinheit (16, 18) zumindest eine Diagnoseeinheit (64, 66) zur Durchführung eines Selbsttest der Messeinheit (16, 18) und/oder zumindest einer Erfassungseinrichtung (20, 22, 24, 26, 28, 30) aufweist.

4. Batteriesensor nach einem der vorhergehenden Ansprüche, **dadurch gekennzeichnet, dass** zumindest einer Erfassungseinrichtung (20, 22, 24, 26, 28, 30) einer Messeinheit (16, 18) ein Filter (32, 48) für den Messwert vorgeschaltet ist.

5. Batteriesensor nach einem der vorhergehenden Ansprüche, **dadurch gekennzeichnet, dass** zumindest eine Messeinheit (16, 18) eine Temperaturerfassungsschaltung (28, 30), insbesondere mit einem innerhalb der Messeinheit (16, 18) angeordneten Temperatursensor (50, 52), aufweist, wobei die ermittelte Temperatur jeweils an die Auswerteschaltung (38, 40) ausgegeben wird, wobei der zumindest eine Batterieparameters aus dem jeweils erfassten zumindest einen Messwert und der ermittelten Temperatur ermittelt wird.

6. Batteriesensor nach Anspruch 5, **dadurch gekennzeichnet, dass** zumindest eine Temperaturerfassungsschaltung (28, 30) mit einem außerhalb der Messeinheit (16, 18) angeordneten Temperatursensor (54) verbunden ist.

7. Batteriesensor nach einem der vorhergehenden Ansprüche, **dadurch gekennzeichnet, dass** zumindest eine Messeinheit (16, 18) eine Referenzschaltung (68) zur Bereitstellung eines Referenzsignals aufweist.

8. Batteriesensor nach einem der vorhergehenden Ansprüche, **dadurch gekennzeichnet, dass** die Messeinheiten (16, 18) auf einer gemeinsamen Leiterplatte (70) angeordnet sind, insbesondere auf entgegengesetzten Flächen der Leiterplatte (70).

9. Batteriesensor nach einem der vorhergehenden Ansprüche, **dadurch gekennzeichnet, dass** eine erste Erfassungseinrichtung (20, 22) der Messeinheiten (16, 18) jeweils eine Spannungserfassungseinrichtung (20, 22) zur Erfassung der Batteriespannung ist, wobei die erste Erfassungseinrichtung (20, 22) insbesondere einen ersten Kontakt (34) zur Kontaktierung mit einem Batteriepol (36) der Fahrzeugbatterie (12) aufweist.

10. Batteriesensor nach einem der vorhergehenden Ansprüche, **dadurch gekennzeichnet, dass** eine zweite Erfassungseinrichtung (24, 26) der Messeinheiten (16, 18) jeweils eine Stromerfassungseinrichtung (24, 26) zur Erfassung des Batteriestroms ist.

11. Batteriesensor nach Anspruch 10, **dadurch gekennzeichnet, dass** die Stromerfassungseinrichtungen (24, 26) eine Messstrecke (42) aufweisen, insbesondere eine gemeinsame Messstrecke (42), wobei ein erster Messwert an einem ersten Kontakt an einem ersten Ende (44) der Messstrecke (42) erfasst wird und ein zweiter Messwert an einem zweiten Kontakt an einem zweiten Ende (46) der Messstrecke (42) erfasst wird.

12. Batteriesensor nach einem der vorhergehenden Ansprüche, **dadurch gekennzeichnet, dass** die Messstrecke (42) zumindest einen Messwiderstand mit einem definierten elektrischen Widerstand aufweist, und die Messwerte Spannungen sind.

## Claims

1. Battery sensor (10) for sensing at least one battery parameter, having at least two measuring units (16, 18), wherein the measuring units (16, 18) each comprise at least one sensing device (20, 22, 24, 26, 28, 30) for sensing at least one measured value, wherein the measuring units (16, 18) each comprise at least one evaluation circuit (38, 40) for determining at least one battery parameter from the respectively sensed at least one measured value, wherein at least one evaluation unit (58) is provided, which compares the battery parameters determined by the evaluation circuits (38, 40), and outputs an error signal in the event that a defined difference between the battery parameters is exceeded, **characterized in that** the same battery parameter is determined by each of the measuring units.

2. Battery sensor according to Claim 1, **characterized in that** an evaluation unit (58) is integrated in at least one evaluation circuit (38, 40), wherein the evaluation circuits (38, 40) are connected to each other by a signal line (56), via which the battery parameters are transferred to the evaluation unit (58).

3. Battery sensor according to either of the preceding claims, **characterized in that** at least one measuring unit (16, 18) comprises at least one diagnostics unit (64, 66) for performing a self-test of the measuring unit (16, 18) and/or of at least one sensing device (20, 22, 24, 26, 28, 30).

4. Battery sensor according to any of the preceding claims, **characterized in that** a filter (32, 48) for the measured value is connected in front of at least one sensing device (20, 22, 24, 26, 28, 30) of a measuring unit (16, 18).

5. Battery sensor according to any of the preceding claims, **characterized in that** at least one measuring unit (16, 18) comprises a temperature-sensing circuit (28, 30), in particular having a temperature sensor (50, 52) arranged inside the measuring unit (16, 18), wherein the determined temperature is output to the evaluation circuit (38, 40) respectively, wherein the at least one battery parameter is determined from the respectively sensed at least one measured value and from the determined temperature.

6. Battery sensor according to Claim 5, **characterized in that** at least one temperature-sensing circuit (28, 30) is connected to a temperature sensor (54) arranged outside the measuring unit (16, 18).

7. Battery sensor according to any of the preceding claims, **characterized in that** at least one measuring unit (16, 18) comprises a reference circuit (68) for providing a reference signal.

8. Battery sensor according to any of the preceding claims, **characterized in that** the measuring units (16, 18) are arranged on a shared circuit board (70), in particular on opposite faces of the circuit board (70).

9. Battery sensor according to any of the preceding claims, **characterized in that** a first sensing device (20, 22) of the measuring units (16, 18) is respectively a voltage-sensing device (20, 22) for sensing the battery voltage, wherein the first sensing device (20, 22) comprises in particular a first contact (34) for making contact with a battery pole (36) of the vehicle battery (12).

10. Battery sensor according to any of the preceding claims, **characterized in that** a second sensing device (24, 26) of the measuring units (16, 18) is respectively a current-sensing device (24, 26) for sensing the battery current.

11. Battery sensor according to Claim 10, **characterized in that** the current-sensing devices (24, 26) comprise a measurement segment (42), in particular a shared measurement segment (42), wherein a first measured value is sensed at a first contact at a first end (44) of the measurement segment (42), and a second measured value is sensed at a second contact at a second end (46) of the measurement segment (42).

12. Battery sensor according to any of the preceding claims, **characterized in that** the measurement segment (42) comprises at least one measurement resistor of defined electrical resistance, and the measured values are voltages.

## Revendications

1. Capteur de batterie (10) destiné à acquérir au moins un paramètre de batterie, comprenant au moins deux unités de mesure (16, 18), les unités de mesure (16, 18) possédant respectivement au moins un dispositif d'acquisition (20, 22, 24, 26, 28, 30) destiné à acquérir au moins une valeur de mesure, les unités de mesure (16, 18) possédant respectivement au moins un circuit d'évaluation (38, 40) destiné à déterminer au moins un paramètre de batterie à partir de la valeur de mesure respectivement acquise, au moins une unité d'évaluation (58) étant présente, laquelle compare les paramètres de batterie déterminés par les circuits d'évaluation (38, 40) et délivre un signal d'erreur en cas de dépassement d'un écart défini entre les paramètres de batterie, **caractérisé en ce que** le même paramètre de batterie est respectivement déterminé par les unités de mesure.

2. Capteur de batterie selon la revendication 1, **caractérisé en ce qu'**une unité d'évaluation (58) est intégrée dans au moins un circuit d'évaluation (38, 40), les circuits d'évaluation (38, 40) étant reliés entre eux par une ligne de signal (56) par le biais de laquelle les paramètres de la batterie sont communiqués à l'unité d'évaluation (58).

3. Capteur de batterie selon l'une des revendications précédentes, **caractérisé en ce qu'**au moins une unité de mesure (16, 18) possède au moins une unité de diagnostic (64, 66) destiné à réaliser un autotest de l'unité de mesure (16, 18) et/ou au moins un dispositif d'acquisition (20, 22, 24, 26, 28, 30).

4. Capteur de batterie selon l'une des revendications précédentes, **caractérisé en ce qu'**un filtre (32, 48) pour la valeur de mesure est branché en amont d'au moins un dispositif d'acquisition (20, 22, 24, 26, 28, 30) d'une unité de mesure (16, 18).

5. Capteur de batterie selon l'une des revendications précédentes, **caractérisé en ce qu'**au moins une unité de mesure (16, 18) possède un circuit d'acquisition de température (28, 30), notamment doté d'un capteur de température (50, 52) disposé à l'intérieur de l'unité de mesure (16, 18), la température déterminée étant respectivement délivrée au circuit d'évaluation (38, 40), l'au moins un paramètre de batterie étant déterminé à partir de l'au moins une valeur de mesure respectivement acquise et de la température déterminée.

6. Capteur de batterie selon la revendication 5, **caractérisé en ce qu'**au moins un circuit d'acquisition de température (28, 30) est relié à un capteur de température (54) disposé à l'extérieur de l'unité de mesure (16, 18).

7. Capteur de batterie selon l'une des revendications précédentes, **caractérisé en ce qu'**au moins une unité de mesure (16, 18) possède un circuit de référence (68) destiné à fournir un signal de référence.

8. Capteur de batterie selon l'une des revendications précédentes, **caractérisé en ce que** les unités de mesure (16, 18) sont disposées sur une carte de circuit imprimé (70) commune, notamment sur des surfaces opposées de la carte de circuit imprimé (70).

9. Capteur de batterie selon l'une des revendications précédentes, **caractérisé en ce qu'**un premier dispositif d'acquisition (20, 22) des unités de mesure (16, 18) est respectivement un dispositif d'acquisition de tension (20, 22) destiné à détecter la tension de la batterie, le premier dispositif d'acquisition (20, 22) possédant notamment un premier contact (34) destiné à la mise en contact avec un pôle de batterie (36) de la batterie de véhicule (12).

10. Capteur de batterie selon l'une des revendications précédentes, **caractérisé en ce qu'**un deuxième dispositif d'acquisition (24, 26) des unités de mesure (16, 18) est respectivement un dispositif d'acquisition de courant (24, 26) destiné à détecter le courant de la batterie.

11. Capteur de batterie selon la revendication 10, **caractérisé en ce que** les dispositifs d'acquisition de courant (24, 26) possèdent une section de mesure (42), notamment une section de mesure (42) commune, une première valeur de mesure étant acquise au niveau d'un premier contact à une première extrémité (44) de la section de mesure (42) et une deuxième valeur de mesure étant acquise au niveau d'un deuxième contact à une deuxième extrémité (46) de la section de mesure (42).

12. Capteur de batterie selon l'une des revendications précédentes, **caractérisé en ce que** la section de mesure (42) possède au moins une résistance de mesure ayant une résistance électrique définie, et les valeurs de mesure sont des tensions.
